# EUROPÄISCHE PATENTSCHRIFT

(11) **EP 2 201 304 B1**
(45) Veröffentlichungstag und Bekanntmachung des Hinweises auf die Patenterteilung: **30.05.2012**
(21) Anmeldenummer: 08840930.5
(22) Anmeldetag: 22.10.2008
(51) Int. Cl.: F24F 3/16

(54) **LAGERANORDNUNG MIT VORGEBBARER LAGERUNGSATMOSPHÄRE**
STORAGE CONFIGURATION HAVING PREDETERMINABLE STORAGE ATMOSPHERE
DISPOSITIF DE STOCKAGE A ATMOSPHÈRE DE STOCKAGE PRÉDÉFINIE

(30) Priorität: 25.10.2007 DE 102007051726
(43) Veröffentlichungstag der Anmeldung: 30.06.2010
(73) Patentinhaber: HÄNEL & CO., CH-9450 Altstätten SG (CH)
(72) Erfinder: ELLWANGER, Harald, 74196 Neuenstadt (DE)
(74) Vertreter: Preissner, Nicolaus
(86) Internationale Anmeldenummer: PCT/EP2008/064266
(87) Internationale Veröffentlichungsnummer: WO 2009/053380

(56) Entgegenhaltungen:
- WO-A-94/17336
- DE-A1-102005 050 010
- JP-A- 55 074 749
- JP-A- 2000 264 405
- JP-A- 2002 155 635
- US-A- 5 997 398
- US-A1- 2003 050 005

## Beschreibung

Die vorliegende Erfindung betrifft eine Lageranordnung mit einer vorgebbaren Lagerungsatmosphäre, gemäß dem Oberbegriff von Anspruch 1. Eine derartige Lageranordnung ist aus US 5 997 398 bekannt.

Lageranordnungen der eingangs genannten Art werden zur Lagerung von Lagergut verwendet, das auf Umgebungsbedingungen besonders sensibel reagiert. Beispiele für derartiges Lagergut sind verderbliche Gegenstände, die beispielsweise kühl gelagert werden müssen oder Halbleiterprodukte, die in unfertiger Form staubgeschützt zu lagern sind.

Lageranordnungen für diesen Zweck sind aus dem Stand der Technik bekannt.

So zeigt die DE 10 2004 014 937 A1 eine Lageranordnung mit vorgegebener Lagerungsatmosphäre, bei der an einem Lagerraum an zwei Seitenwänden Luftkanäle angeordnet sind. Zwischen den Luftkanälen und dem Lagerraum befindet sich eine Trennwand, die Öffnungen verschiedener Größe aufweist. Einer der Kanäle ist als Zuluftkanal, der andere als Abluftkanal ausgebildet.

Die Kanäle sind so mit einer über der Decke des Lagerraums angeordneten Konditioniereinrichtung verbunden, dass die Luft aus dem Abluftkanal von der Konditioniereinrichtung aufbereitet und dann durch den Zuluftkanal und die Öffnungen in der Trennwand zu dem Lagerraum wieder in den Lagerraum eingeblasen wird.

Die JP 10-291607 A zeigt ebenfalls einen Lagerraum, in dem mit Hilfe von Konditioniereinrichtungen eine kontinuierliche Belüftung mit Luft, die bestimmte Eigenschaften aufweist, gewährleisten soll. Der Lagerraum ist dazu in Abstellflächen unterteilt, die eine offene Seite zur Außenseite des Lagerraums und zu Zuluftkanälen aufweisen und die zu einer Mitte des Lagerraums hin offen sind. Die konditionierte Luft wird von den Seiten in den Lagerraum eingeblasen und im Bodenbereich in der Mitte des Lagerraums wieder abgesaugt.

Bei den vorstehend genannten Lageranordnungen wird der Lagerraum in Horizontalrichtung von Luft durchströmt.

Die vorliegende Erfindung geht auf die Aufgabe zurück, eine Lageranordnung der eingangs genannten Art zu schaffen, die bei einfacher Konstruktion eine verbesserte Reinraumtauglichkeit aufweist.

Zur Lösung dieser Aufgabe wird bei einer Lageranordnung der eingangs genannten Art vorgeschlagen, dass die Lagergutträger luftdurchlässig ausgebildet sind, wobei der Boden der Lagergutträger Öffnungen aufweist, durch die Luft strömen kann, d.h. die Absaug- und Einblasöffnungen sind so angeordnet, dass die Luft den Lagerraum in Vertikalrichtung durchströmt.

Die erfindungsgemäße Lageranordnung weist den Vorteil auf, dass durch die vertikale Luftführung im Lagerraum Partikel, die sich auf horizontalen Flächen angelagert haben, durch den Luftstrom nicht oder nur in sehr geringem Maße aufgewirbelt werden. Dadurch verringert sich die Partikeldichte der Luft in dem Lagerraum, was zu verbesserten Reinraumeigenschaften führt.

Vorteilhafte Ausgestaltungen der Erfindung sind Gegenstand der Unteransprüche.

Vorteilhaft ist die Einblasöffnung an einem Deckenabschnitt angeordnet und die Absaugöffnung an einem Bodenabschnitt angeordnet. Dies hat den Vorteil, dass Partikel, selbst wenn sie von dem Luftstrom mitgetragen werden, sukzessive mit der Schwerkraft nach unten wandern und sich somit am Boden beziehungsweise in der abgesaugten Luft sammeln und so leichter aus dem Lagerraum entfernt werden können. Dies bewirkt eine weiter verbesserte Reinraumtauglichkeit der Lageranordnung.

Die Einblasöffnung und/oder die Absaugöffnung können als Lochblech ausgebildet sein. Dies ist statisch günstiger als große Öffnungen vorzusehen und beeinträchtigt einen Luftstrom nur unerheblich.

Vorteilhaft ist die Absaugöffnung im unteren Bereich der Seitenwände des Lagerraums vorgesehen. Dadurch können Unterbauten, die ein unter dem Lagerraum angeordneter Absaugkanal mit sich bringen würde, vermieden werden und so der Lagerraum einfacher an einem vorhandenen Untergrund abgestützt werden.

Vorteilhaft sind die Lagergutträger luftdurchlässig ausgebildet. Dies trägt wesentlich dazu bei, dass der vertikale Luftstrom den Lagerraum ungehindert passieren kann.

Der Boden der Lagergutträger kann dazu Öffnungen aufweisen, durch die die Luft strömen kann.

Vorteilhaft sind die Böden der Lagergutträger als Lochblech ausgeführt. Dies gewährleistet eine gute Luftdurchlässigkeit bei gleichzeitig hoher Stabilität der Lagergutträger.

In einer vorteilhaften Ausgestaltung bildet die Fläche der Öffnungen wenigstens 5 % der Fläche der Böden der Lagergutträger. Die stellt sicher, dass die Luft ausreichend gleichmäßig vertikal strömen kann.

Die Konditioniereinrichtung weist vorteilhaft einen Partikelfilter auf, der zur Reinigung der Luft ausgebildet ist. Dadurch ist es möglich, die aus dem Lagerraum abgesaugte Abluft von Stäuben und kleinen Partikeln zu reinigen, und die Luft sauber zu halten.

In vorteilhafter Ausführung sind mittels der Konditioniereinrichtung in dem Lagerraum Reinraumbedingungen herstellbar.

Die Konditioniereinrichtung kann ein Heizelement aufweisen, mit dem die Luft erwärmbar ist. Dies ist notwendig für Lagergut, das bei einer bestimmten Mindesttemperatur zu lagern ist.

Weiter kann die Konditioniereinrichtung ein Kühlelement aufweisen, mit dem die Luft kühlbar ist. Dies hat den Vorteil, dass auch Lagergut eingelagert werden kann, bei dem die Lagertemperatur einen Höchstwert nicht überschreiten darf.

Die Feuchte der Luft kann mittels der Konditioniereinrichtung steuerbar sein.

In vorteilhafter Ausgestaltung weist der Lagerraum mit der Konditioniereinrichtung verbundene Sensoren auf, mit deren Hilfe die Umweltbedingungen in dem Lagerraum regelbar sind. Durch die Ausstattung mit derartigen Sensoren kann eine Art Klimaanlage für das eingelagerte Lagergut bereitgestellt werden.

Zur Umwälzung der Luft kann die Konditionierungseinheit eine Ventilationseinheit aufweisen. Ventilationseinheiten mit elektrisch angetriebenen Motoren sind einfach zu verwenden und zum Lufttransport effizient einsetzbar.

Die Lageranordnung kann als Umlaufregal ausgebildet sein, wobei die Transporteinrichtung die Lagergutträger umlaufend fördert.

Weiterhin kann die Lageranordnung als Vertikallift ausgebildet sein, wobei die Transporteinrichtung die Lagergutträger in dem Lagerraum vorgesehenen Lagerplätzen zustellt oder entnimmt.

Im Weiteren wird die Erfindung anhand von Ausführungsbeispielen näher beschrieben, die schematisch in den beigefügten Zeichnungen dargestellt sind. Es zeigen:
- Fig. 1: einen Querschnitt durch eine Lageranordnung gemäß einer ersten Ausführungsform der vorliegenden Erfindung;
- Fig. 2: einen Lagergutträger zur Verwendung in der Lageranordnung aus Fig. 1;
- Fig. 3: eine Draufsicht auf den Lagerraum aus Fig. 1;
- Fig. 4: eine Seitenansicht auf die Lageranordnung aus Fig. 1 mit einem Durchbruch durch die Außenwand;
- Fig. 5: eine Lageranordnung gemäß einer zweiten Ausführungsform der vorliegenden Erfindung.
- Fig. 6: eine Draufsicht auf einen Lagergutträger für die Lageranordnung aus Fig. 5;

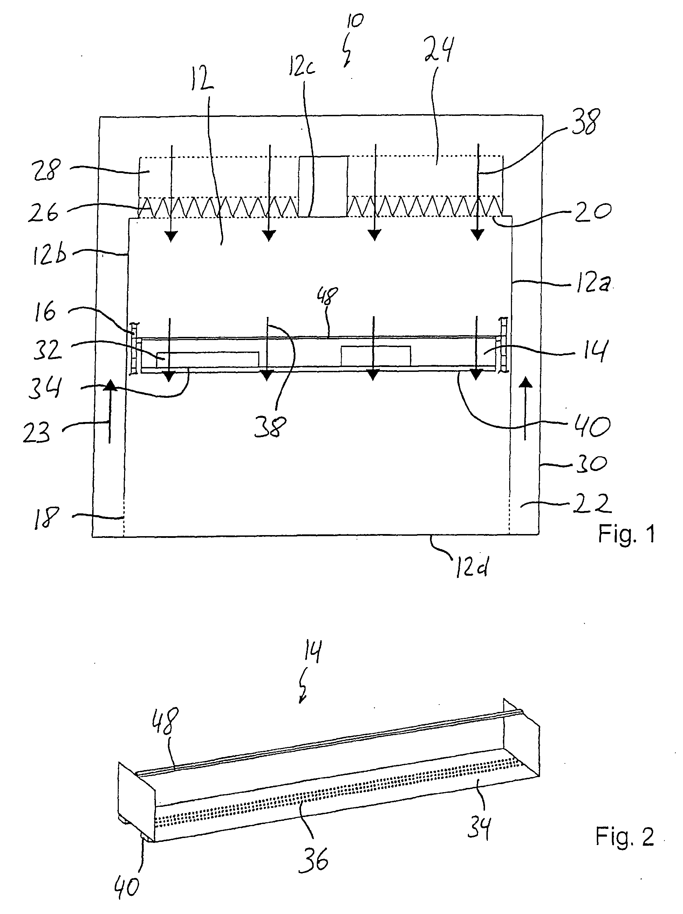

Die in Fig. 1 gezeigte erste Ausführungsform der Lageranordnung 10 weist einen Lagerraum 12 mit Seitenwänden 12a, 12b auf. In dem Lagerraum ist eine Transporteinrichtung 16 vorgesehen, mit der Lagergutträger 14 transportierbar sind. Der Lagerraum 12 wird durch einen Deckenabschnitt 12c und einen Bodenabschnitt 12d begrenzt.

In der Nähe des Bodenabschnitts 12d sind in die Seitenwände 12a, 12b des Lagerraums 12 Absaugöffnungen 18 eingebracht. Der Deckenabschnitt 12c weist Einblasöffnungen 20 auf.

Außerhalb des Lagerraums 12 sind entlang der Seitenwände 12a, 12b Abluftschächte 22 vorgesehen, durch die Abluft 23 geführt wird.

Auf die Einblasöffnungen 20 ist an der Außenseite des Deckenabschnitts 12c des Lagerraums 12 eine Konditioniereinrichtung 24 aufgesetzt. Die Konditioniereinrichtung 24 weist einen Partikelfilter 26 und eine daran angeschlossene Ventilationseinheit 28 auf. Bei eingeschalteter Ventilationseinheit 28 wird Luft 38 in vertikaler Richtung transportiert.

Alternativ kann der Lagerraum 12 keinen Deckenabschnitt 12c aufweisen und nach oben offen sein. In diesem Fall ist die Konditionierungseinrichtung 24 an der Deckenöffnung des Lagerraums 12 angeordnet.

Die gesamte Lageranordnung 10 ist von einem Gehäuse 30 umgeben, welches die Lageranordnung 10 im Wesentlichen luftdicht von der Außenwelt abschließt und zusammen mit den Seitenwänden 12a, 12b des Lagerraums 12 die Abluftschächte 22 begrenzt.

Die Transporteinrichtung 16 ist als Kette ausgebildet, an der eine Vielzahl von Lagergutträgern 14 so befestigt ist, dass sie paternosterartig umlaufend förderbar sind.

Die Lagergutträger 14 weisen, wie in Fig. 2 zu sehen ist, einen Boden 34 auf, auf dem Lagergut 32 abstellbar ist.

Um eine bessere Durchströmung der Lagergutträger 12 mit Luft 38 zu erlauben, weist der Boden 34 der Lagergutträger 14 Öffnungen 36 auf, die durch Verwendung eines Lochblechs realisiert werden. Des Weiteren weist der Lagergutträger 14 keine Vorder- oder Rückwand auf, was ein Umströmen des Lagergutträgers 14 durch die Luft 38 erleichtert.

Damit die Öffnungen 36 die Stabilität des Lagergutträgers 14 nicht beeinträchtigen sind bei dem Lagergutträger 14 Verstärkungselemente 40 vorgesehen, die ein Durchbiegen des Bodens 34 des Lagergutträgers 14 verhindern. Zur weiteren Stabilisierung weist der Lagergutträger 14 einen Stützbügel 48 auf. Der Stützbügel 48 kann zusätzlich der Anbringung des Lagergutträgers 14 an der Transporteinrichtung 16 dienen.

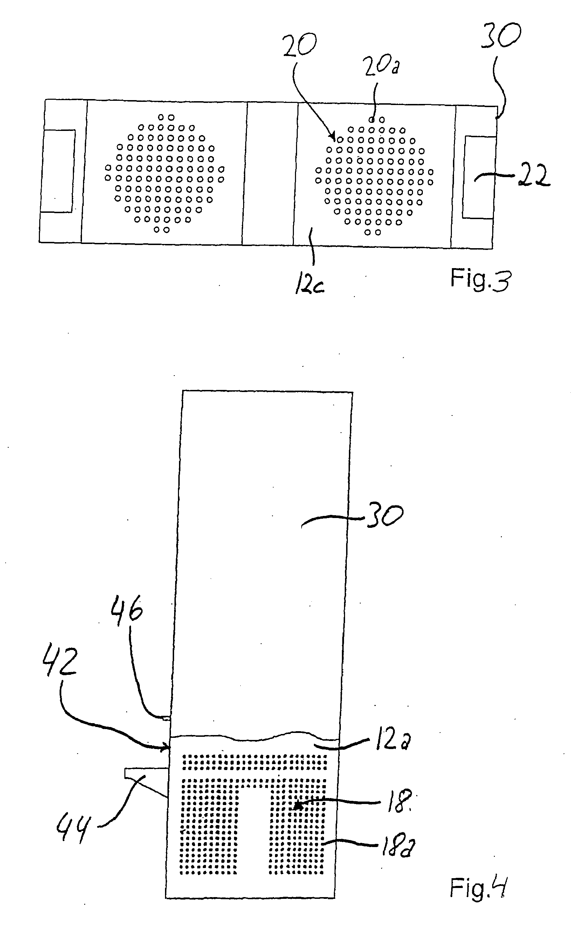

Um die Stabilität der Lageranordnung möglichst wenig zu beeinträchtigen sind die Einblasöffnungen 20 wie in Fig. 3 gezeigt als Lochblech mit Öffnungen 20a realisiert. Die Öffnungen 20a sind dabei nur in dem Bereich vorgesehen, in dem Luft 38 von der Ventilationseinheit 28 in den Lagerraum 12 eingeblasen wird.

Aus demselben Grund sind die Absaugöffnungen 18 als Lochbleche mit Öffnungen 18a ausgebildet, wie in Fig. 4 zu sehen ist. Auch hier sind in einem stabilitätsrelevanten Bereich keine Öffnungen 18a ausgebildet.

Zur Entnahme und Einlagerung von Lagergut 32 ist eine Beschickungs- und Entnahmeöffnung 42 vorgesehen, die einen Ablagetisch 44 und eine Bedienleiste 46 aufweist. Soll Lagergut 32 aus einem Lagergutträger 14 entnommen oder in einen solchen eingelagert werden, so wird der Lagergutträger 14 in die Beschickungs- und Entnahmeöffnung 42 verfahren und kann von einem Bediener benutzt werden.

Um den Lagerraum 12 zu belüften und darin eine staub- und partikelarme Atmosphäre zu schaffen, wird die Luft 38 in einem Kreislauf durch das Gehäuse 30 und den Lagerraum 12 transportiert.

Die Ventilationseinheit 28 bläst die Luft 38 durch den Partikelfilter 26, der die Luft 38 von Staub und Partikeln reinigt. Sodann strömt die Luft 38 durch die Einblasöffnungen 20 in den Lagerraum 12 und durchströmt diesen in vertikaler Richtung. Die transportierte Luftmenge kann dabei beispielsweise im Bereich um 1500 m³/h liegen. Je nach Größe des Lagerraums 12 und dem Neuverschmutzungsgrad der Luft 38 ist die Luftmenge den Verhältnissen anzupassen.

Die vertikale Strömung wird von den Öffnungen 36 in den Böden der Lagergutträger 14 erleichtert. Die Öffnungen 36 ermöglichen es somit, in einem Großteil des Lagerraums 12 eine gleichmäßige vertikale Strömung zu erreichen.

Sobald die Luft 38 an dem Bodenabschnitt 12d angelangt ist, wird sie durch die Absaugöffnungen 18 mittels des sich auf der Ansaugseite der Ventilationseinheit 28 ausbildenden Unterdrucks aus dem Lagerraum 12 herausgesaugt und als Abluft 23 durch den Abluftschacht 22 wieder der Ventilationseinheit 28 zugeführt.

Durch diesen Luftkreislauf, in dem die Luft 38 bei jedem Durchlauf von Partikeln gereinigt wird, können in dem Lagerraum 12 Reinraumbedingungen hergestellt werden. In dem Lagerraum 12 wird ein Überdruck eingestellt, um ein Eindringen von Schmutzpartikeln zu verhindern.

Insbesondere wird die Ausbildung von Reinraumbedingungen dadurch begünstigt, dass die Luftströmung Staub und Partikel nicht aufwirbelt, sondern in Richtung der Schwerkraft auf den Boden zu transportiert. Somit sind sämtliche Einwirkungen auf lösbaren Staub und Partikel auf den Bodenabschnitt 12d zu gerichtet, was zu einem effizienten Absaugen des Staubs und der Partikel mit der Abluft 23 durch die Absaugöffnungen 18 führt.

Die in dem ersten Ausführungsbeispiel gezeigte Lageranordnung 10 ist als Umlaufregal ausgebildet. Die dargelegten Effekte sind jedoch ebenfalls in einem Vertikallift auf identische Art und Weise nutzbar.

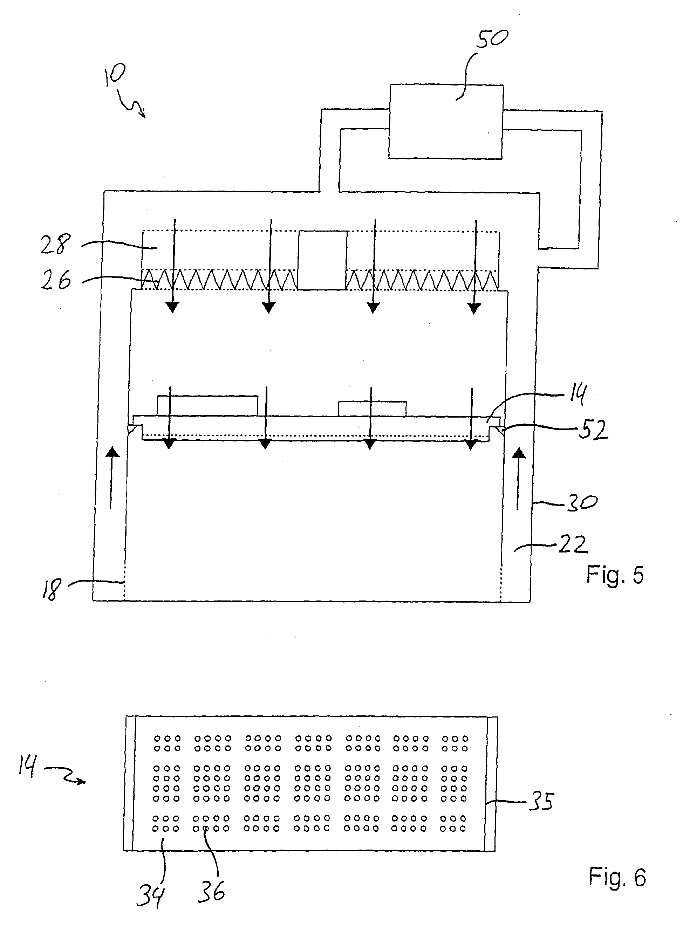

Fig. 5 zeigt eine zweite Ausführungsform, die als Vertikallift ausgebildet ist. Hierbei sind an den Seitenwänden 12a, 12b des Lagerraums 12 eine Vielzahl von Stützen 52 zur Aufnahme von Lagergutträgern 14 vorgesehen, die mittels einer Transporteinrichtung 16 verfahrbar sind.

Auch ein solcher Lagergutträger 14, der in Fig. 6 dargestellt ist, weist in seinem Boden 34 Öffnungen 36 auf, die die vertikale Strömung der Luft 38 in dem Lagerraum 12 passieren lassen. An den Stirnflächen haben die Lagergutträger 14 Führungsstufen 35 zur Führung der Lagergutträger 14 an den Stützen 52.

Die Lageranordnung 10 kann außer mit einer Ventilationseinheit 28 und einem Partikelfilter 26 zusätzlich mit weiteren Aggregaten ausgestattet sein.

Bei der in Fig. 5 gezeigten zweiten Ausführungsform der Lageranordnung 10 ist eine Klimatisierungseinrichtung 50 vorgesehen, mittels derer die Temperatur in dem Lagerraum 12 steuer- beziehungsweise regelbar ist.

Die Klimatisierungseinrichtung 50 ist im Bereich der Abluft 22 angeordnet, um den Effekt von Staub- und Partikeleinstreuungen so gering wie möglich zu halten.

Weitere Aggregate, wie beispielsweise Luftbefeuchter, Lufttrockner oder Einrichtungen zur Ausbildung einer Schutzatmosphäre sind selbstverständlich ebenfalls in der Lageranordnung 10 verwendbar.

Solche Aggregate können in den Abluftschacht 22 integriert werden um sicherzustellen, dass sämtliche Abluft 23 von den Aggregaten konditioniert wird.

Ebenso ist es möglich, die Konditioniereinrichtung 24 und die Klimatisierungseinrichtung 50 sowie weitere Aggregate separat von der Lageranordnung 10 aufzubauen und mit geeigneten Luftführungseinrichtungen, beispielsweise Schläuchen, mit den Abluftschächten 22 und den Einblasöffnungen 20 zu verbinden.

Sowohl bei dem Umlaufregal als auch bei dem Vertikallift sind die Aggregate, Konditionierungs- und Klimatisierungseinrichtungen frei kombinierbar.

Die Öffnungen 18a, 20a, 36 können jede beliebige Form aufweisen, insbesondere kreis- oval- oder rechteckförmig ausgebildet sein.

Die erfindungsgemäße Lageranordnung 10 verbessert die Reinraumfähigkeit eines Lagerraums 12 gegenüber dem Stand der Technik durch ihre vertikale Luftführung, die Staub und Partikel gezielt zu einer Absaugöffnung 18 lenkt.

### Bezugszeichenliste

- 10: Lageranordnung
- 12: Lagerraum
- 12a: Seitenwand
- 12b: Seitenwand
- 12c: Deckenabschnitt
- 12d: Bodenabschnitt
- 14: Lagergutträger
- 16: Stütze
- 18: Absaugöffnung
- 18a: Öffnung
- 20: Einblasöffnungen
- 20a: Öffnung
- 22: Abluftschacht
- 23: Abluft
- 24: Konditioniereinrichtung
- 26: Partikelfilter
- 28: Ventilationseinheit
- 30: Gehäuse
- 32: Lagergut
- 34: Boden
- 35: Führungsstufe
- 36: Öffnung
- 38: Luft
- 40: Verstärkungselement
- 42: Beschickungs- und Entnahmeöffnung
- 44: Ablagetisch
- 46: Bedienleiste
- 48: Stützbügel
- 50: Klimatisierungseinrichtung

## Patentansprüche

1. Lageranordnung (10) mit einer vorgebbaren Lagerungsatmosphäre, mit einem Lagerraum (12) zur Aufnahme einer Vielzahl von Lagergutträgern (14) für Lagergut (32), die mittels einer Transporteinrichtung (16) einer Beschickungs- und Entnahmeöffnung (42) zur Ein- und Auslagerung des Lagerguts (32) zustellbar sind, und mit einer dem Lagerraum (12) zugeordneten Konditioniereinrichtung (24), die über am Lagerraum (12) vorgesehene Absaug- und Einblasöffnungen (18, 20) Luft aus dem Lagerraum (12) absaugt, aufbereitet und wieder in den Lagerraum (12) einbläst, wobei die Absaug- und Einblasöffnungen (18, 20) so angeordnet sind, dass die Luft den Lagerraum (12) in Vertikalrichtung durchströmt, **dadurch gekennzeichnet, dass** die Lagergutträger (14) luftdurchlässig ausgebildet sind, wobei der Boden (34) der Lagergutträger (14) Öffnungen (36) aufweist, durch die Luft strömen kann.

2. Lageranordnung nach Anspruch 1, **dadurch gekennzeichnet, dass** die Einblasöffnung (20) in oder an einem Deckenabschnitt (12c) angeordnet ist und die Absaugöffnung (18) in oder an einem Bodenabschnitt (12d) angeordnet ist.

3. Lageranordnung nach einem der voranstehenden Ansprüche, **dadurch gekennzeichnet, dass** die Einblasöffnung (20) und/oder die Absaugöffnung (18) als Lochblech ausgebildet sind.

4. Lageranordnung nach einem der voranstehenden Ansprüche, **dadurch gekennzeichnet, dass** die Absaugöffnung (18) im unteren Bereich von Seitenwänden (12a, 12b) des Lagerraums (12) vorgesehen ist.

5. Lageranordnung nach einem der voranstehenden Ansprüche, **dadurch gekennzeichnet, dass** der Boden (34) der Lagergutträger (14) als Lochblech ausgeführt ist.

6. Lageranordnung nach einem der voranstehenden Ansprüche, **dadurch gekennzeichnet, dass** die Fläche der Öffnungen (36) wenigstens 5% der Fläche des Bodens (36) der Lagergutträger (14) bildet.

7. Lageranordnung nach einem der voranstehenden Ansprüche, **dadurch gekennzeichnet, dass** die Konditioniereinrichtung (24) einen Partikelfilter (26) zur Reinigung der Luft aufweist.

8. Lageranordnung nach Anspruch 7, **dadurch gekennzeichnet, dass** mittels der Konditioniereinrichtung (24) in dem Lagerraum (12) Reinraumbedingungen herstellbar sind.

9. Lageranordnung nach einem der voranstehenden Ansprüche, **dadurch gekennzeichnet, dass** die Konditioniereinrichtung (24) ein Heizelement aufweist, mit dem die Luft erwärmbar ist.

10. Lageranordnung nach einem der voranstehenden Ansprüche, **dadurch gekennzeichnet, dass** die Konditioniereinrichtung (24) ein Kühlelement aufweist, mit dem die Luft kühlbar ist.

11. Lageranordnung nach einem der voranstehenden Ansprüche, **dadurch gekennzeichnet, dass** die Feuchte der Luft mittels der Konditionierungseinrichtung (24) steuerbar ist.

12. Lageranordnung nach einem der voranstehenden Ansprüche, **dadurch gekennzeichnet, dass** der Lagerraum (12) mit der Konditionierungseinrichtung (24) verbundene Sensoren aufweist, mit deren Hilfe die Umweltbedingungen in dem Lagerraum (12) regelbar sind.

13. Lageranordnung nach einem der voranstehenden Ansprüche, **dadurch gekennzeichnet, dass** die Konditionierungseinheit (24) eine Ventilationseinheit (28) zur Umwälzung der Luft aufweist.

14. Lageranordnung nach einem der Ansprüche 1 bis 13, **dadurch gekennzeichnet, dass** die Lageranordnung (10) als Umlaufregal ausgebildet ist, wobei die Transporteinrichtung (16) die Lagergutträger (14) umlaufend fördert.

15. Lageranordnung nach einem der Ansprüche 1 bis 13, **dadurch gekennzeichnet, dass** die Lageranordnung (10) als Vertilkallift ausgebildet ist, wobei die Transporteinrichtung (16) die Lagergutträger (14) in dem Lagerraum (12) vorgesehen Lagerplätzen zustellt oder entnimmt.

## Claims

1. Storage configuration (10) having a predeterminable storage atmosphere, with a storage chamber (12) for receiving a plurality of carriers (14) for stored goods (32) which can be delivered to a loading and unloading opening (42) by means of a transport device (16) for storage and retrieval of the stored goods (32), and having an air-conditioning device (24) associated with the storage chamber (12) which, by means of inlet and outlet ports (18, 20) provided on the storage chamber (12), sucks air from the storage chamber (12), processes it and blows it back into the storage chamber (12), wherein the inlet and outlet ports (18, 20) are so arranged on the storage chamber (12) that the air flows through the storage chamber (12) in a vertical direction, **characterised in that** the stored-goods carriers (14) are designed to be permeable to air, wherein the floor (34) of the carrier (14) has apertures (36) through which the air can flow.

2. Storage configuration according to claim 1 **characterised in that** the inlet port (20) is located in or on the ceiling section (12c) and the outlet port (18) is located in or on the floor section (12d).

3. Storage configuration according to one of the preceding claims **characterised in that** the inlet port (20) and / or the outlet port (18) take the form of a perforated metal sheet.

4. Storage configuration according to one of the preceding claims **characterised in that** the outlet port (18) is located in the lower region of the side walls (12a, 12b) of the storage chamber (12).

5. Storage configuration according to one of the preceding claims **characterised in that** the floor (34) of the stored-goods carrier (14) is made of perforated metal sheet.

6. Storage configuration according to one of the preceding claims **characterised in that** the surface area of the apertures (36) accounts for at least 5% of the floor surface of the stored-goods carrier (14).

7. Storage configuration according to one of the preceding claims **characterised in that** the air-conditioning device (24) has a particulate filter (26) for cleaning the air.

8. Storage configuration according claim 7 **characterised in that** clean-room conditions can be produced in the storage chamber (12) by means of the air-conditioning device (24).

9. Storage configuration according to one of the preceding claims **characterised in that** the air-conditioning device (24) has a heating element with which the air can be warmed.

10. Storage configuration according to one of the preceding claims **characterised in that** the air-conditioning device (24) has a cooling element with which the air can be cooled.

11. Storage configuration according to one of the preceding claims **characterised in that** the humidity in the air can be controlled by the air-conditioning device (24).

12. Storage configuration according to one of the preceding claims **characterised in that** the storage chamber (12) is equipped with sensors connected to the air-conditioning device (24) with the help of which the environmental conditions within the storage chamber (12) can be adjusted.

13. Storage configuration according to one of the preceding claims **characterised in that** the air-conditioning unit (24) has a ventilation unit (28) for circulating the air.

14. Storage configuration according to one of the claims 1 to 13 **characterised in that** the storage configuration (10) is configured as a carousel wherein the transport device (16) causes the stored-goods carriers (14) to circulate.

15. Storage configuration according to one of the claims 1 to 13 **characterised in that** the storage configuration (10) is designed as a vertical lift wherein the transport device (16) inserts and removes the stored-goods carriers (14) into/from the prescribed storage spaces in the storage chamber (12).

## Revendications

1. Système de stockage (10) présentant une atmosphère de stockage prédéterminée, comprenant un local de stockage (12) pour recevoir une pluralité de supports de produits (14) pour des produits à stocker (32), les supports étant susceptibles d'être approchés, au moyen d'un dispositif de transport (16), d'une ouverture de chargement et de déchargement (42) pour l'entrée et la sortie des produits à stocker (32), et comprenant un dispositif de conditionnement (24) associé au local de stockage (12), lequel aspire l'air hors du local de stockage (12) via des ouvertures d'aspiration (18) prévues dans le local de stockage (12), le traite, et le souffle à nouveau dans le local de stockage (12) via des ouvertures de soufflage (20) prévues dans le local de stockage (12), lesdites ouvertures d'aspiration et de soufflage (18, 20) étant agencées de telle façon que l'air traverse le local de stockage (12) en direction verticale, **caractérisé en ce que** les supports de produits (14) sont réalisés perméables à l'air, et le fond (34) des supports de produits (14) comporte des ouvertures (36) à travers lesquelles l'air peut s'écouler.

2. Système de stockage selon la revendication 1, **caractérisé en ce que** l'ouverture de soufflage (20) est agencée dans ou sur une portion du plafond (12c) et l'ouverture d'aspiration (18) est agencée dans ou sur une portion du plancher (12d).

3. Système de stockage selon l'une des revendications précédentes, **caractérisé en ce que** l'ouverture de soufflage (20) et/ou l'ouverture d'aspiration (18) sont réalisées sous forme de tôle perforée.

4. Système de stockage selon l'une des revendications précédentes, **caractérisé en ce que** l'ouverture d'aspiration (18) est prévue dans la zone inférieure des murs latéraux (12a, 12b) du local de stockage (12).

5. Système de stockage selon l'une des revendications précédentes, **caractérisé en ce que** le fond (34) des supports de produits (14) est réalisé sous forme de tôle perforée.

6. Système de stockage selon l'une des revendications précédentes, **caractérisé en ce que** la surface des ouvertures (36) forme au moins 5 % de la surface du fond (36) des supports de produits (14).

7. Système de stockage selon l'une des revendications précédentes, **caractérisé en ce que** le dispositif de conditionnement (24) comprend un filtre à particules (26) pour la purification de l'air.

8. Système de stockage selon la revendication 7, **caractérisé en ce que** des conditions de salle blanche peuvent être établies dans le local de stockage (12) au moyen du dispositif de conditionnement (24).

9. Système de stockage selon l'une des revendications précédentes, **caractérisé en ce que** le dispositif de conditionnement (24) comprend un élément chauffant au moyen duquel l'air peut être chauffé.

10. Système de stockage selon l'une des revendications précédentes, **caractérisé en ce que** le dispositif de conditionnement (24) comprend un élément de refroidissement au moyen duquel l'air peut être refroidi.

11. Système de stockage selon l'une des revendications précédentes, **caractérisé en ce que** l'humidité de l'air peut être contrôlée au moyen du dispositif de conditionnement (24).

12. Système de stockage selon l'une des revendications précédentes, **caractérisé en ce que** le local de stockage (12) comprend des capteurs connectés au dispositif de conditionnement (24), à l'aide desquels les conditions ambiantes dans le local de stockage (12) peuvent être régulées.

13. Système de stockage selon l'une des revendications précédentes, **caractérisé en ce que** l'unité de conditionnement (24) comprend une unité de ventilation (28) pour la recirculation de l'air.

14. Système de stockage selon l'une des revendications 1 à 13, **caractérisé en ce que** le système de stockage (10) est réalisé sous forme de rayonnage défilant, et le dispositif de transport (16) convoie les supports de produits (14) en défilement.

15. Système de stockage selon l'une des revendications 1 à 13, **caractérisé en ce que** le système de stockage (10) est réalisé sous forme de système à levage vertical, et le dispositif de transport (16) approche ou enlève les supports de produits (14) vers/depuis des emplacements de stockage prévus dans le local de stockage (12).
